Europäisches Patentamt

European Patent Office

Office européen des brevets

(19)

(11) **EP 0 928 426 B1**

(12) **EUROPÄISCHE PATENTSCHRIFT**

(45) Veröffentlichungstag und Bekanntmachung des Hinweises auf die Patenterteilung:
**05.10.2005 Patentblatt 2005/40**

(51) Int Cl.$^7$: **G01R 33/385**

(21) Anmeldenummer: **97910363.7**

(22) Anmeldetag: **25.09.1997**

(86) Internationale Anmeldenummer:
**PCT/EP1997/005272**

(87) Internationale Veröffentlichungsnummer:
**WO 1998/013703 (02.04.1998 Gazette 1998/13)**

(54) **VERFAHREN UND VORRICHTUNG ZUR MAGNETRESONANZUNTERSUCHUNG**

PROCESS AND DEVICE FOR MAGNETIC RESONANCE EXAMINATION

PROCEDE ET DISPOSITIF D'EXAMEN PAR RESONANCE MAGNETIQUE

(84) Benannte Vertragsstaaten:
**AT BE CH DE FR GB IT LI NL SE**

(30) Priorität: **27.09.1996 DE 19639853**

(43) Veröffentlichungstag der Anmeldung:
**14.07.1999 Patentblatt 1999/28**

(73) Patentinhaber: **Deutsches Zentrum für Luft- und Raumfahrt e.V.**
**53175 Bonn (DE)**

(72) Erfinder: **MELCHER, Jörg**
**D-38165 Lehre (DE)**

(74) Vertreter: **Einsel, Martin**
**Patentanwalt,**
**Jasperallee 1A**
**38102 Braunschweig (DE)**

(56) Entgegenhaltungen:
**EP-A- 0 533 173          WO-A-96/31785**
**DE-A- 4 237 011**

• **D.J. JENSEN ET AL.: "Reduction of pulsed gradient settling time ..." MEDICAL PHYSICS, Bd. 14, 1987, Seiten 859-862, XP002051667**
• **A.M. GOLDMAN ET AL.: "Reduction of Sound Levels with Antinoise in MR Imaging" RADIOLOGY, Bd. 173, 1989, Seiten 549-550, XP000120249**

## Beschreibung

Die Erfindung betrifft ein Verfahren zur Magnetresonanzuntersuchung, insbesondere Kernspintomographie, bei dem ein statisches Magnetfeld in einem Untersuchungsraum erzeugt wird, bei dem diesem statischen Magnetfeld wenigstens zwei im wesentlichen senkrecht zueinander orientierte, von einem Sequenzsignal gesteuerte Gradientenmagnetfelder überlagert werden, bei dem durch die Gradientenmagnetfelder unerwünschte wechselnde elektromagnetische Kräfte entstehen, bei dem eine Filterung wenigstens eines der Gradientenmagnetfelder erfolgt, sowie eine Vorrichtung zur Magnetresonanzuntersuchung, insbesondere Kernspintomographie, mit einer ersten Erzeugungseinrichtung für ein statisches Magnetfeld, mit wenigstens zwei Einrichtungen zur Erzeugung eines Gradientenmagnetfeldes, die im wesentlichen senkrecht zueinander orientierte Gradientenmagnetfelder erzeugen, und mit einem gemeinsamen Sequenzgenerator zur Ansteuerung der Einrichtungen zur Erzeugung eines Gradientenmagnetfeldes, mit einem Filter.

Magnetresonanzuntersuchungen erlauben einen Einblick in feste, flüssige oder gasförmige Proben. Bei dem auch als Kernspinresonanz-Spektroskopie bezeichneten Untersuchungsverfahren werden bestimmte, in den Proben enthaltene Atomkerne in einem statischen Magnetfeld angeregt. Die Kernspins präzidieren dabei - klassisch betrachtet - um die Richtung des statischen Magnetfeldes. Die kernmagnetische Resonanz beruht auf einer Eigenschaft des Atomkerns, dem Spin, nach der Kerne in starken Magnetfeldern Energie in Form elektromagnetischer Wellen im Radiofrequenzbereich aufnehmen und abgeben können. Betrachtet wird bei dem Effekt stets eine bestimmte Atomart. Die Resonanzfrequenz ist proportional zur Magnetfeldstärke am Kernort, wobei das gyromagnetische Verhältnis $\gamma$ die kernphysikalische Naturkonstante ist. Den stärksten Resonanzeffekt (größte Empfindlichkeit) haben Wasserstoffkerne, deren Resonanzfrequenz z. B. bei 0,5 Tesla bei 21,3 MHz, bei 1,0 Tesla bei 42,6 MHz und entsprechend bei 1,5 Tesla bei 64 MHz liegt. Angeregt wird die Kernspinresonanz durch hochfrequente magnetische Wechselfelder in den Richtungen x, y und z. Im Fall der Übereinstimmung von Resonanzfrequenz und Frequenz des äußeren Feldes wird die Kernmagnetisierung der Probe bzw. des Gewebes aus dem Feld herausgedreht. Der Betrag der Auslenkung charakterisiert den Anregungsimpuls.

Unter Berücksichtigung verschiedener Effekte (Magnetisierung, Längs- und Querrelaxation) müssen die Hochfrequenz-Signale zur Bildgebung dem Objekt räumlich zugeordnet werden. Grundsätzlich wird daher jeweils bei Anregung bzw. Auslesen des Signals ein "Feldgradient" angelegt. Dieser Feldgradient entspricht einer definierten linearen Magnetfeldstärkenänderung in einer Raumrichtung. Die Resonanzfrequenz $\omega$ ist dann eine Funktion der Koordinate, z. B. $\omega(x) = \gamma \cdot G_x \cdot x$ (Larmorrelation mit Gradient $G_x$).

Derartige Magnetresonanz-Untersuchungsverfahren werden hauptsächlich in der Medizintechnik eingesetzt. Die Kernspinresonanz-Spektroskopie erlaubt einen nicht-invasiven Einblick in den menschlichen Stoffwechsel. Darüber hinaus finden die Magnetresonanz-Untersuchungsverfahren in der Atom- und Kernphysik sowie in der Festkörperphysik Anwendung.

Gerade in der klinischen Magnetresonanz-Spektroskopie muß die Information über den Stoffwechsel in einem bestimmten Gewebe, also die räumliche Auflösung des Magnetresonanz-Gerätes optimiert sein. Je nach Anwendung werden daher unterschiedliche Lokalisationstechniken (schichtselektive Anregung, Phasenkodierung, begrenzter Empfindlichkeitsbereich von Oberflächenspulen und Kombinationen davon) benutzt. Es kann dabei leicht gezeigt werden, daß die Auflösung maßgeblich von den Signalsequenzen, mit denen die Gradientenspulen gespeist werden, abhängt. Je größer das Verhältnis von Impulshöhe zu Anstiegszeit ist, desto besser ist die Auflösung. Es ist also vorteilhaft, hohe Amplituden bei kurzen Anstiegszeiten zu verwenden.

Typische Magnetresonanz-Anlagen haben ein Röhrensystem, in dessen Zentrum der Patient hineingeschoben wird. Die Magnetfelder werden elektrisch durch Spulensysteme, die in dem Röhrensystem integriert sind, generiert.

Die Ströme I verursachen das Magnetfeld der magnetischen Induktion B. Aufgrund der bewegten Ladung im Magnetfeld werden elektromagnetische Kräfte, nämlich Lorentz-Kräfte F erzeugt, deren Betrag senkrecht zur Magnetfeld- und Stromrichtung maximal ist. Die Leiter, also hier die Spulen, erfahren die Lorentzkraft F derart, dass sie ihrerseits strukturelle Vibrationen, nämlich die Eigenformen des Röhrensystems in Form verschiedener radialer und axialer Moden erzeugen können. Diese Vibrationen gehen stets mit einer nicht zu vernachlässigenden Luftschallabstrahlung einher. Das ganze Röhrensystem wirkt dabei - akustisch betrachtet - als Lautsprechermembran. Aufgrund der extrem hohen Ströme, die durch die Spule fliessen, sind die Kräfte und damit auch die Schalldrücke hoch. Derartige Schalldrücke von 120 dB und mehr liegen im Bereich der Schmerzgrenze und erzeugen nicht nur Angst- und Bedrohungsgefühle beim Patienten, sondern können auch lebensbedrohend sein. Letzteres ist bei Schalldrücken von mehr als 140 dB gegeben.

Weiterhin treten durch die Treiberströme der Gradientenfeld-Spannungsquelle Wirbelströme auf. Diese verschlechtern die Bildqualität des Magnetresonanzbildes. EP 0 533 173 A1 schlägt ein Verfahren vor, um eine solche Verschlechterung des Bildes zu vermeiden. Ziel hierbei ist die Bereitstellung eines Magnetresonanz-Bildgebeverfahrens und eines Magnetresonanz-Bildgebesystems, die eine Kompensation hinsichtlich eines gestörten Gradientenfeldes, dessen Störungen durch das Wirbelstromfeld hervorgerufen werden, durchführen können, um dabei ein gewünschtes Gradientenfeld zu erzeugen. Ein weiteres Ziel besteht in der Schaffung eines Magnetresonanz-Bildgabesystems, das eine einfache Gradientenfeld-Erzeugungeinheit aufweist, die eine Kompensation hinsichtlich eines asymmetrisch gestörten Gradientenfeldes durchführen kann. Bei EP 0 533 173 A1 wird der Gradientenspule ein Treiberstrom zugeführt, der einen den Wirbelstrom kompensierenden Strom enthält.

Ein passiver Gehörschutz, direkt am menschlichen Gehör, reicht daher bei weitem nicht mehr aus. Als weitere passive Maßnahme wurde vorgeschlagen, das die Gradientenspulen haltende Röhrensystem mechanisch zu versteifen. Die bisherigen Ergebnisse sind allerdings mangelhaft.

Gemäß der DE 44 32 747 A1 ist daher ein Kernspintomographie-Gerät und-Verfahren mit einer aktiven Geräuschdämpfung vorgeschlagen worden. Dort wird mit piezoelektrischen Bauelementen, die dämpfungsfrei an einem die Gradientenmagnetfeldspule haltenden Halteteil befestigt sind, eine Kraft zum Verhindern der Verformung angelegt, in dem die an das piezoelektrische Bauelement angelegte Spannung geeignet gesteuert wird. Die piezoelektrischen Bauelemente werden entweder nach einer für bestimmte, festgelegte Anregungssignalsequenzen der Gradientenspulen experimentell angepaßten und gespeicherten Steuerkurve oder auf Grundlage von Meßergebnissen einer Verformungsmeßeinrichtung im Halteteil angesteuert. Nachteilig ist der erhebliche Regelaufwand für die Ansteuerung der piezoelektrischen Bauelemente. Dieses System ist daher sehr kostenaufwendig.

Ferner ist aus dem Artikel "Vibration Control of a Cylindrical Shell Used in MRI Equipment" von Qui, J. und Tani, J. in Smart Materials and Structures, Vol. 4, Seiten A75-A81, 1995 eine aktive Schwingungsdämpfung von zylindrischen Hohlkörpern in Magnetresonanzgeräten bekannt. Zur Dämpfung von Eigenschwingungen des Hohlzylinders ist eine Vielzahl von piezoelektrischen Aktuatoren an geeigneten Positionen vorzusehen. Nachteilig ist auch hier der erhebliche apparative und regelungstechnische Aufwand.

Aufgabe der Erfindung ist es daher, die bei Magnetresonanzuntersuchungen auftretenden Schalldrücke wirksam mit vertretbarem Aufwand zu verringern.

Gelöst wird diese Aufgabe verfahrensgemäss dadurch, dass das Sequenzsignal für wenigstens ein Gradientenmagnetfeld breitbandig analog oder digital gewichtend gefiltert wird, dass die Filterung im Frequenzbereich zwischen 0 und 2 kHz erfolgt, und dass das Steuersignal für das wenigstens eine Gradientenmagnetfeld so gefiltert wird, dass eine destruktive Interferenz der im Tomographen entstehenden mechanischen Kräfte erreicht wird, indem eine Gegenphasigkeit für zwei Gradientenmagnetfelder für diesen Frequenzbereich erzeugt wird.

Vorrichtungsgemäss wird die Aufgabe bei einer eingangs genannten Vorrichtung dadurch gelöst, dass vor wenigstens einer Einrichtung zur Erzeugung eines Gradientenmagnetfeldes ein analoges oder digitales eine Gewichtung vornehmendes Filter vorgeschaltet ist, dass das Filter im Bereich zwischen 0 und 2 kHz arbeitet, und dass das Filter so eingestellt ist, dass die Einrichtung zur Erzeugung des Gradientenmagnetfeldes eine destruktive Interferenz der im Tomographen entstehenden mechanischen Kräfte erreicht, indem eine Gegenphasigkeit für zwei Gradientenmagnetfelder für diesen Frequenzbereich erzeugt wird.

Bevorzugt ist ein Verfahren vorgesehen, dass ein im Untersuchungsraum angeordneter Sensor den Schalldruck misst und die Messwerte den die Filterung vornehmenden Elementen zuführt, und dass diese das Sequenzsignal adaptiv oder mit einem Adaptionsalgorithmus filtern.

Durch das Filtern der zur Erzeugung der gewünschten Gradientenmagnetfelder verwendeten Signalsequenz, die beispielsweise in einer Gewichtung im Frequenzbereich besteht, werden die bei der Erzeugung der Gradientenmagnetfelder entstehenden Lorentzkräfte so eingestellt, daß weitestgehend eine destruktive Interferenz der im Tomographen entstehenden mechanischen Kräfte erreicht wird.

Die destruktive Interferenz wird dadurch erreicht, daß die Gradientenspulen gegenphasig laufen. Eine Anpassung oder Gewichtung erfolgt insbesondere in einem Frequenzbereich von 0 bis 2 kHz durch ein Filter. Experimentell wird dabei das Filter optimal an den speziellen Anwendungsfall vor Inbetriebnahme der Vorrichtung angepaßt durch Einstellen seiner dann für den weiteren Betrieb konstanten Parameter für die jeweilige Vorrichtung. Da weitere Anpassungen während des Betriebes der Vorrichtung, beispielsweise durch unterschiedlich schwere Personen, erforderlich werden können, wird ein vorzugsweise adaptives Filter vorgesehen. Bei einem solchen Filter sind insbesondere bei Wahl eines digitalen Filters in der Filtergleichung Variablen vorgesehen, die hier eine Anpassung ermöglichen.

Die Folge dieser Maßnahmen ist eine reduzierte Schwingung des Tomographen, so daß eine deutlich reduzierte Schallabstrahlung erreicht wird. Es wird nämlich eine dynamische Versteifung vorgenommen. Diese ersetzt somit den Idealfall eines dickwandigen, unendlich steifen Zylinders, bei dem gar keine Schwingungen aufträten.

Dadurch, daß die Filterungen auf eine vorermittelte Funktion eingestellt werden, wobei Filterkorrekturen für Schwingungsveränderungen je nach Lage des Untersuchungsobjekts im Untersuchungsraum angewendet werden, kann auch die durch Einführung des zu untersuchenden Objekts in den Untersuchungsraum herrührende Magnetfeldänderung berücksichtigt werden. Die vorermittelte Filterfunktion wird also vorgegeben nachgestellt, so daß mit der Filterung weiterhin optimale Schallunterdrückung erreicht wird.

Es erfolgt dabei eine breitbandige Verarbeitung, wobei in einem Linienspektrum alle Frequenzen gleichzeitig angeregt werden. Als Antwort auf eine Anregung eines Systems durch einen Einheitsimpuls oder Diracimpuls ergibt sich bekanntlich eine Gewichtsfunktion $g(t)$. Das System stellt dabei die Übertragungsstrecke dar. Die Gewichtsfunktion bescheibt somit das zu untersuchende System. Koeffizienten sind dabei entsprechend Gewichtungsfaktoren. In Abhängigkeit von den Filterparametem tritt auch eine Änderung des Magnetfeldes auf. Es erfolgt stets eine Anpassung an eventuelle Änderungen des Systems, seien sie auf der primären oder auf der sekundären Seite. Eine eventuell auftretende Phasenänderung wird durch die adaptive Filterung kompensiert, wodurch am Ende der Übertragungsstrecke eine gewünschte Phasendrehung von 180° verbleibt.

Ist das System nichtlinear, wie dies im allgemeinen der Fall sein wird, tauchen im Antwortspektrum höhere harmonische Anregungen auf. Auch diese können durch das Vorsehen eines adaptiven Filters abgefangen werden, wobei eine breitbandige Verarbeitung sogleich mittels des Filters erfolgt. Das Filter ist entweder im Ansteuerungssignalweg der X-Spule oder der Y-Spule oder im Ansteuerungssignalweg von beiden Spulen vorgesehen. Ebenso ist es möglich, ein entsprechendes Filter in den Ansteuerungssignalweg der Z-Spule zu legen, jedoch ist dies in den meisten Fällen nicht unbedingt erforderlich. Im allgemeinen wird das Vorsehen lediglich eines Filters bereits ausreichend sein.

Wenn die Schwingungsveränderungen im Untersuchungsraum erfaßt werden und danach Korrekturen für die Filterungen berechnet werden, können die tatsächlichen Veränderungen im Untersuchungsraum bei der Berechnung der Filterkoeffizienten berücksichtigt werden. Die vorermittelte Filterfunktion wird also entsprechend den Meßergebnissen nachjustiert, um wieder eine optimale Schallreduktion zu erreichen.

Aufgrund des in Frequenzinhalt und/oder Phasenlage veränderten Signals von wenigstens einem Gradientenmagnetfeld durch die Filterung muß die Meßdatenauswertung der Magnetresonanzuntersuchung an das gefilterte Sequenzsignal angepaßt werden. Dies geschieht vorzugsweise durch Rückmeldung der Filterparameter an den Auswerterechner des Tomographen.

Vorrichtungsgemäß wird durch die Vorschaltung eines Filters vor einer Einrichtung zur Erzeugung eines Gradientenmagnetfeldes eine Ansteuerung ermöglicht, die die in der Struktur des Tomographen wirkenden Kräfte weitestgehend gegenseitig kompensiert. Erreicht wird damit eine breitbandig und räumlich wirksame, effiziente Lärmreduktion. Bevorzugt ist das Filter als digitales oder analoges Filtersystem ausgebildet.

Bei Vorsehen eines analogen Filters geschieht eine breitbandige Verarbeitung, die jedoch keine Anpassung bzw. Adaption in dem Sinne aufweist, daß ein Adaptionsalgorithmus oder Filtersystem vorgesehen wäre. Bei Vorsehen eines digitalen Filters wird besonders bevorzugt ein Transversalfilter als digitales FIR-Filter oder aber ein IIR-Filter, also ein Transversal- und Rekursivfilter, oder ein Lettis-Filter vorgesehen. Eine Adaption kann dabei in Kombination mit einem Adaptionsalgorithmus erfolgen. Ein solcher Filteralgorithmus, insbesondere FIR-LMS (Least-Mean-Square) weist beispielsweise folgende Formel auf:

$$h(n+1) = \gamma h(n) - 2\,\mu\,x(n)\,e(n) \tag{1},$$

wobei $\gamma$: Leakage-Faktor mit $0 \leq \gamma \leq 1$,

$$e(n) = f(n) = f(t = n\,T) = f_n : \text{Eingangsfunktion mit Abtastzeit } T,$$

n Element der ganzen Zahlen ohne Null,
x (n) gemessenes Ausgangssignal als Fehler- bzw. Abweichungsquelle, welche entsprechend dem Adaptionsalgorithmus wieder aufgegeben wird,
h (n) = [h (t = 0), h (t = 1 T), h (t = 2T), ...] : Echoamplituden zu Abtastzeiten T, Koeffizientenvektor.
Das adaptive Filter kann beides, Amplitude und Phase des Ausgangssignales variieren, gerade so, wie es erforderlich ist, um das entsprechende, in den Adaptionsalgorithmus zurückgeführte Fehlersignal zu reduzieren. Das Fehlersignal ist hierbei die als Lärm wirkende Schwingung der Gradientenspulen. Als Schrittgrößenparameter definiert die Konstante $\mu$ einen Kompromiß zwischen Genauigkeit und Konvergenzrate. Der Parameter $\gamma$ ist eine positive reale Konstante zwischen 0 und 1. Im allgemeinen wird die Wahl von $\gamma \leq$ und sehr nahe bei 1 Instabilitäten vermeiden helfen. Diese Methode wird als "Leaky LMS"-Algorithmus bezeichnet. Für breitbandige Verarbeitungen wird ein Übertragungssystem verwendet, welches ein digitales FIR-Filter und einen "Leaky LMS-Algorithmus" aufweist. Die Filterfunktion kann im Zeitbereich durch folgende Formel beschrieben werden:

$$f_l(n) = \sum_{i=0}^{L} h_l v_l(n-i) \tag{2},$$

wobei $h_i$ Filterkoeffizienten sind, die die diskrete Impulsantwort der Übertragungsfunktion nach dem Adaptionsprozeß wiedergeben. Das digitale FIR-Filter wird in jedem Abtastschritt auf den neuesten Zustand gebracht. h (n + 1) berechnet sich dann nach folgender Formel:

$$h (n + 1) = h (n) + 2 \mu \, \delta (n) \, v (n) \tag{3},$$

wobei $\delta(n)$ die von einem $\delta$-Abtaster in bestimmten Zeitabschnitten abgetasteten Signale sind und $\delta(n)$ den alle korrespondierenden Gradientenkomponenten beinhaltenden Vektor darstellt und h(n) den Koefffizienten-Vektor. Eine konstante Verzögerungszeit von m Schritten kompensiert eventuelle Dekorrelationen und wird lediglich einmal zu Beginn des Adaptionsvorganges gesetzt.

Alternativ zu dem FIR-Filter kann ein ebenfalls für breitbandige Verarbeitung geeignetes IIR-Filter verwendet werden. Wie das FIR-Filter ist auch das IIR-Filter als Transversalfilter aufgebaut, zusätzlich jedoch noch als rekursives Filter. Im Zeitbereich kann ein solches Filter durch folgende Formel dargestellt werden:

$$f_i (n) = \sum_{i=0}^{L} a_i v_f (n-i) + \sum_{j=1}^{L} b_j f_i (n-j) \tag{4},$$

oder im Frequenzbereich:

$$A(z) = \sum_{i=0}^{L} a_i z^{-i} \text{ und } B (z) = \sum_{j=1}^{L} b_j z^{-j} \tag{5},$$

wobei die Übertragungsfunktion ausgedrückt wird durch:

$$F (z) = \frac{A(z)}{1 - B(z)} \tag{6},$$

wobei die Koeffizienten $b_j$ die rekursiven Komponenten der Funktion $f_i$ gewichten. Der Adaptionsalgorithmus LMS des FIR-Filters wird zum rekursiven LMS-Adaptionsalgorithmus. Seine Formeln lauten dann wie folgt:

$$a (n + 1) = a(n) + 2 \mu \, \delta_t(n) \, v (n) \tag{7}$$

$$b (n + 1) = b(n) + 2 \mu \, \delta_r (n) \, v (n) \tag{8},$$

wobei $\delta_t (n)$ ein Gradientenvektor ist, der mit den Transversalkoeffizienten korrespondiert, die aus dem Eingangssignalbereich berechnet werden und $\delta_r (n)$ ein Gradientenvektor ist, der sich auf die rekursiven Gewichtsfaktoren b (n) bezieht, die aus der Ausgangsfunktion $f_i$ errechnet werden. Darüberhinaus werden gemäß dem rekursiven Teil der Funktion F(z) die korrekten Gradienten $\delta_t$ und $\delta_r$ durch Filtern mit der Übertragungsfunktion 1/1-B erhalten.

Im Ergebnis wird mit der Filterung eine destruktive Interferenz der an den Einrichtungen zur Erzeugung von Gradientenmagnetfeldern wirkenden mechanischen Kräfte erreicht. Damit wird die aufgrund von Schwingungen entstehende Schallabstrahlung am Magnetresonanzgerät gedämpft.

Bei üblichen Magnetresonanzgeräten besteht die Gradientenmagnetfelderzeugungseinrichtung aus einer Spule, bevorzugt einer Sattelspule. Da insbesondere die Gradientenspulen in X- und Y-Richtung zur Deformation der röhrenförmig ausgebildeten Halteeinrichtung führen, wird bevorzugt eine der X- oder Y-Gradientenspulen mit einem Filter versehen. Auch die Z-Gradientenspule kann, ebenso wie zwei beliebige Gradientenspulen oder, falls erforderlich, sogar alle drei Gradientenspulen mit einem (jeweiligen) Filter versehen werden.

Dadurch, daß akustische oder strukturdynamische Sensoren im Untersuchungsraum vorgesehen sind, die eine Korrektur der Filterung bewirken, können veränderbare Einflüsse auf das im Untersuchungsraum herrschende Magnetfeld, beispielsweise durch Einführen des Untersuchungsobjekts in den Untersuchungsraum, für die Filterung berücksichtigt werden.

Insbesondere bei einem digitalen Filtersystem kann die Korrektur der Filterung durch Umrechnung der Filterkoeffizienten berechnet werden.

Durch das Gegeneinanderwirken von x- und y-Gradientenspulen tritt keine Primäranregung mehr auf, jedoch wird der medizintechnische Effekt verschlechtert. Bei der Auswertung der mittels des Tomographen ermittelten Ergebnisse kann dies berücksichtigt werden. Hierbei wird die Transformationsgleichung für das Skannen genutzt.

Nachfolgend wird die Erfindung an einem Ausführungsbeispiel anhand der Zeichnungen detailliert beschrieben.

Darin zeigt:

Fig. 1    ein Blockdiagramm der erfindungsgemäßen Ansteuerung zweier Gradientenspulen,
Fig. 2    zwei senkrecht zueinander orientierte Gradientenspulenpaare in schematischer dreidimensionaler Ansicht,
Fig. 3    die Verformung einer zylindrischen Spulenhalterung aufgrund von Lorentzkräften und
Fig. 4    ein Blockdiagramm eines adaptiven Filtersystems mit zugeordnetem Adaptionsalgorithmus.

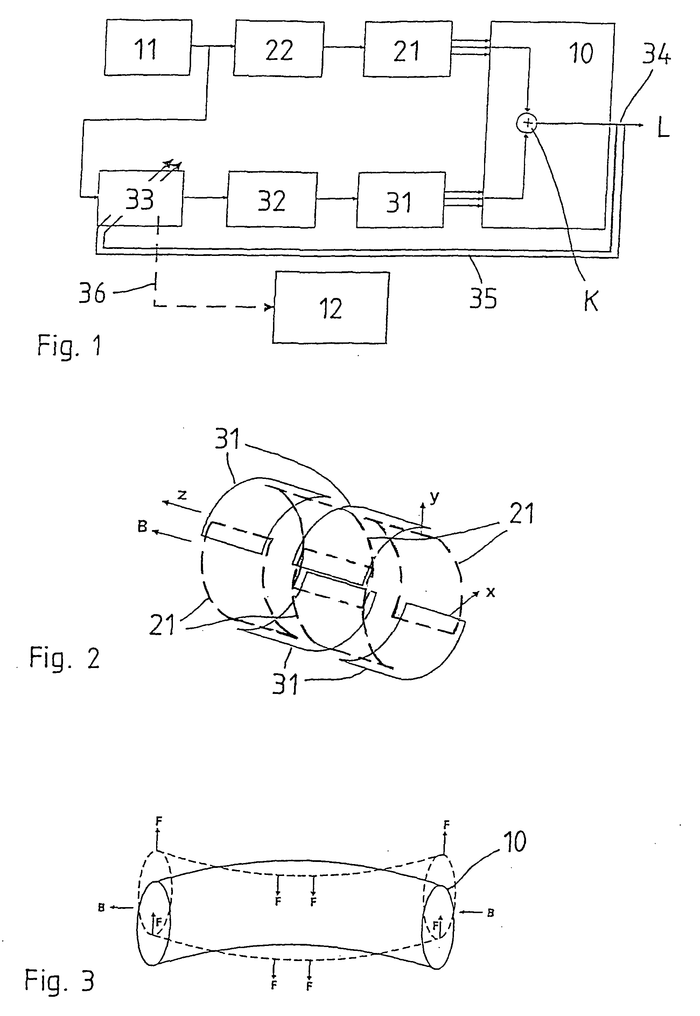

In **Figur 1** ist ein Blockdiagramm der erfindungsgemäßen Ansteuerung zweier Gradientenspulen 21, 31 dargestellt.

In bekannten Magnetresonanztomographen sind zur Erzeugung der Gradientenmagnetfelder die Spulen in besonderer Anordnung auf einer zylindrischen Halterungseinrichtung 10 angeordnet. In **Figur 2** sind in schematischer, dreidimensionaler Ansicht die beiden Gradientenspulenpaare 21, 31 dargestellt. Das Gradientenspulenpaar 21 erzeugt ein Gradientenmagnetfeld in X-Richtung gemäß dem in Fig. 2 dargestellten kartesischen Koordinatensystem. Das Gradientenspulenpaar 31 erzeugt ein entsprechendes Gradientenmagnetfeld in Y-Richtung. Die als Sattelspulen ausgebildeten Gradientenspulenpaare 21, 31 sind auf der Mantelfläche der Halteeinrichtung 10 um 90° verdreht um die mit der Zylinderachse zusammenfallende Z-Achse angeordnet.

Die Z-Gradientenspule ist in Fig. 2 der Übersichtlichkeit halber nicht dargestellt. Die Z-Gradientenspule ist um die zylindrische Halteeinrichtung 10 gewickelt. In der Spulenhälfte mit Z > 0 ist der Leiter der Spule in der einen Richtung, in der anderen Spulenhälfte in der entgegengesetzten Richtung gewickelt. Zusammen erzeugen die zwei Spulenhälften ein lineares Gradientenfeld entlang der Z-Achse.

In Fig. 2 ist die magnetische Induktion B dargestellt, die zu einem durch einen in der Y-Gradientenspule 31 fließenden Strom verursachten Gradientenmagnetfeld gehört. Der elektrische Strom bzw. die im Leiter bewegte Ladung erzeugt im Magnetfeld Lorentz-Kräfte F, die senkrecht zur Magnetfeld- und Stromrichtung gerichtet sind. Die sich aus den an den Spulen wirkenden Kräften F bildenden Verformungen sind in **Figur 3** als Beispiel einer axialen Eigenform der zylindrischen Halteeinrichtung 10 schematisch dargestellt. Die als dünnwandiger Zylinder wirkende Halteeinrichtung 10 vollführt somit in Abhängigkeit von der an die Gradientenspulen 21, 31 angelegten Signalsequenz Vibrationen oder Schwingungen in seinen Eigenformen, meist in einer Mischform aus axialen und radialen Eigenformen verschiedener Ordnung, auch Schwingungsmoden genannt.

Die in Fig. 2 nicht dargestellte Z-Gradientenspule erzeugt Kräfte in Richtung der Zylinderachse (Z-Achse) der Halteeinrichtung 10 in dessen Richtung die Halteeinrichtung sehr steif ist und somit nur unwesentlich zur Schallabstrahlung beiträgt. Demgegenüber ist in X- und Y-Richtung, in der jeweils ein lineares, radiales Gradientenfeld vorliegt, die Steifigkeit der zylindrischen Halteeinrichtung 10 geringer, so daß die extremen Schallpegel vorrangig durch diese Spulenpaare erzeugt werden.

Diese auftretenden Kräfte erzeugen bei bekannten Vorrichtungen in Fig. 3 schematisch dargestellte Amplituden von beispielsweise 150 µm in X- und Y-Richtung bei ca. 1 kHz am Ort der maximalen Auslenkung, dem Spulenende.

In Fig. 1 ist das Blockdiagramm der Ansteuerung der beiden Gradientenspulen 21, 31 dargestellt. Die als zylinderförmige Röhre ausgebildete Halteeinrichtung 10 für die beiden dargestellten Gradientenspulen 21, 31 in der Anordnung in Fig. 2 wird von einem Sequenzgenerator 11 angesteuert. Das Steuersignal des Sequenzgenerators 11 wird über je einen den Spulen zugeordneten Spulenverstärker 22, 32 für den Einsatzzweck entsprechend verstärkt. Der X-Spulenverstärker 22, der das X-Gradientenspulenpaar 21 versorgt, wird direkt von dem Sequenzgenerator 11 angesteuert. Der Y-Spulenverstärker 32, der das Y-Gradientenspulenpaar 31 versorgt, wird von dem Sequenzgenerator 11 über ein Filter 33 angesteuert.

Das durch das Filter 33 veränderte Signal des Sequenzgenerators 11 erfährt eine Gewichtung im Frequenzbereich sowie ggf. eine Phasenverschiebung gegenüber dem direkt auf den X-Spulenverstärker 22 gelegten Sequenzsignal.

In dem Röhrensystem 10 wird durch die am stromdurchflossenen Leiter der Gradientenspulen 21, 31 wirkenden Lorentzkräfte eine Deformation hervorgerufen. Der Kraftfluß K im Röhrensystem 10 wird dabei durch Wahl einer geeigneten Filterung im Filter 33 auf eine destruktive Interferenz, also eine Gegenphasigkeit, abgestimmt. Die ggf.

nicht vollständig ausgeglichene Kräfteverteilung erzeugt Schwingungen geringer Amplitude, die zu einer erheblich geringeren Lärmabstrahlung L im Untersuchungsraum des Tomographen führen.

Im innerhalb der Halteeinrichtung 10 ausgebildeten Untersuchungsraum sind Sensoren 34 angeordnet, die den induzierten Schalldruck L messen und über Wirkleitung 35 an das Filter 33 melden. Das Filter 33 erfährt Korrekturen aufgrund der von den Sensoren 34 gemessenen Daten. Mit dieser Rückkopplung können Veränderungen des Magnetfeldes aufgrund des in den Untersuchungsraum geschobenen Meßobjektes berücksichtigt werden.

Bevorzugt ist das Filter 33 als digitales Filtersystem ausgebildet, so daß die Meßdaten der Sensoren 34 mit einem Adaptionsalgorithmus direkt zu einer Neuberechnung von Filterkoeffizienten verwendet werden können. Damit kann der gewünschte Kräfteausgleich zur optimalen Schallunterdrückung entsprechend justiert werden. Die Filterdaten des Filters 33 werden über Datenleitung 36 an den Auswerterechner 12 des Tomographen übertragen. Im Auswerterechner 12 werden dann die Filterwerte des Filters 33 bei der Meßdatenauswertung berücksichtigt.

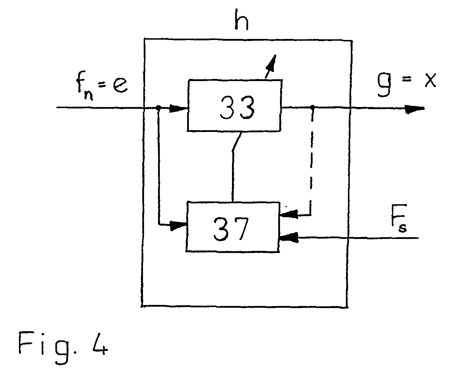

In **Figur 4** ist in separierter Darstellung das Filter 33 mit zugeordnetem Adaptionsalgorithmus 37 gezeigt. Eingangssequenz $f_n$ ist das vom Sequenzgenerator stammende Signal bzw. die Sequenz, die Filter und Algorithmus aufgegeben wird. Der Algorithmus 37 bildet in vorgegebenen Zeiteinheiten nach Formel (1) jeweils ein Update für das Filter 33 unter Verwendung des Ausgangssignales g des Filters bzw. der Fehlersequenz $F_s$, die sich als Abweichung vom vorgegebenen gewollten Ausgangssignal ergibt.

Ein solches adaptives Filtersystem kann aus einem digitalen FIR-Filter 33 und einem zugeordneten FIR-LMS-Adaptionsalgorithmus 37 aufgebaut sein.

**Bezugszeichenliste**

10 Halteeinrichtung
11 Sequenzgenerator
12 Meßauswerterechner

21 X-Gradientenspulenpaar
22 X-Spulenverstärker

31 Y-Gradientenspulenpaar
32 Y-Spulenverstärker
33 Filter
34 Sensor
35 Wirkleitung
36 Datenleitung
37 Adaptionsalgorithmus

F Lorentz-Kraft
K Kraftflußverteilung
L Lärmschallpegel
B Induktion
x,y,z Koordinaten

$F_s$ Fehlersequenz

**Patentansprüche**

1. Verfahren zur Magnetresonanzuntersuchung, insbesondere Kernspintomographie,
   bei dem ein statisches Magnetfeld in einem Untersuchungsraum erzeugt wird,
   bei dem diesem statischen Magnetfeld wenigstens zwei im wesentlichen senkrecht zueinander orientierte, von einem Sequenzsignal gesteuerte Gradientenmagnetfelder überlagert werden,
   bei dem durch die Gradientenmagnetfelder unerwünschte wechselnde elektromagnetische Kräfte entstehen,
   bei dem eine Filterung wenigstens eines der Gradientenmagnetfelder erfolgt,
   **dadurch gekennzeichnet,**
   **dass** das Sequenzsignal für wenigstens ein Gradientenmagnetfeld breitbandig analog oder digital gewichtend gefiltert wird,

**dass** die Filterung im Frequenzbereich zwischen 0 und 2 kHz erfolgt,
und **dass** das Sequenzsignal für das wenigstens eine Gradientenmagnetfeld so gefiltert wird, dass eine destruktive Interferenz der im Tomographen entstehenden Kräfte erreicht wird, indem eine Gegenphasigkeit für zwei Gradientenmagnetfelder für diesen Frequenzbereich erzeugt wird.

2. Verfahren nach Anspruch 1, **dadurch gekennzeichnet, dass** ein im Untersuchungsraum angeordneter Sensor (34) den Schalldruck (L) misst und die Messwerte den die Filterung vornehmenden Elementen zuführt, und dass diese das Sequenzsignal adaptiv oder adaptiv mit einem Adaptionsalgorithmus filtern.

3. Verfahren nach Anspruch 1 oder 2, **dadurch gekennzeichnet,**
**dass** die Schwingungsveränderungen im Untersuchungsraum erfasst werden und danach Korrekturen für die Filterungen berechnet werden.

4. Verfahren nach Anspruch 1, 2 oder 3, **dadurch gekennzeichnet,**
**dass** die Filterung auf eine vorermittelte Funktion eingestellt wird, wobei Filterkorrekturen für Schwingungsveränderungen je nach Lage des Untersuchungsobjekts im Untersuchungsraum angewendet werden.

5. Verfahren nach einem der vorhergehenden Ansprüche, **dadurch gekennzeichnet,**
**dass** die Messdatenauswertung der Magnetresonanzuntersuchung an das gefilterte Sequenzsignal angepasst wird.

6. Verfahren nach einem der vorstehenden Ansprüche, **dadurch gekennzeichnet**,
der Adaptionsalgorithmus folgende Formel aufweist:

$$h(n+1) = \gamma * h(n) - 2\mu * x(n) * e(n)$$

mit $\gamma$: Leakage-Faktor mit $0 \leq \gamma \leq 1$,
$e(n) = f(n) = f(t = nT) = f_n$: Eingangsfunktion mit Abtastzeit T,
n: Element der ganzen Zahlen ohne Null,
$x(n) = g(n)$: gemessenes Ausgangssignal,
$h(n) = [(t=0), h(t=1T), h(t=2T), ...]$: Koeffizientenvektor.

7. Vorrichtung zur Magnetresonanzuntersuchung, insbesondere Kernspintomographie,
mit einer ersten Erzeugungseinrichtung für ein statisches Magnetfeld,
mit wenigstens zwei Einrichtungen (21, 31) zur Erzeugung eines Gradientenmagnetfeldes, die im wesentlichen senkrecht zueinander orientierte Gradientenmagnetfelder erzeugen,
mit einem gemeinsamen Sequenzgenerator (11) zur Ansteuerung der Einrichtungen (21, 31) zur Erzeugung eines Gradientenmagnetfeldes, mit einem Filter (33).
**dadurch gekennzeichnet,**
**dass** vor wenigstens einer Einrichtung (31) zur Erzeugung eines Gradientenmagnetfeldes ein analoges oder digitales, eine Gewichtung vornehmendes Filter (33) vorgeschaltet ist, und
**dass** das Filter im Bereich zwischen 0 und 2 kHz arbeitet, und dass das Filter (33) so eingestellt ist, dass die Einrichtung (31) zur Erzeugung des Gradientenmagnetfeldes eine destruktive Interferenz der im Tomographen entstehenden mechanischen Kräfte erreicht, indem eine Gegenphasigkeit für zwei Gradientenmagnetfelder für diesen Frequenzbereich erzeugt wird.

8. Vorrichtung nach Anspruch 7, **dadurch gekennzeichnet, dass** das Filter (33) als breitbandiges digitales oder analoges Filtersystem ausgebildet ist.

9. Vorrichtung nach Anspruch 7 oder 8, **dadurch gekennzeichnet,**
**dass** ein adaptives Filter oder ein Filter mit einem Adaptionsalgorithmus, insbesondere einem FIR-Least Mean Square-Algorithmus, vorgesehen ist.

10. Vorrichtung nach einem der Ansprüche 7 bis 9, **dadurch gekennzeichnet,**
**dass** das Filter (33) ein digitales FIR-, IIR- oder Lettis-Filter ist.

11. Vorrichtung nach einem der Ansprüche 7, 8 oder 9, **dadurch gekennzeichnet,**

**dass** akustische oder strukturdynamische Sensoren (34) im Untersuchungsraum vorgesehen sind, die eine adaptive Korrektur der Filterung bewirken.

12. Vorrichtung nach einem der Ansprüche 7 bis 11, **dadurch gekennzeichnet,**
    **dass** bei einem digitalen Filtersystem (33) em Rechner zur Korrektur der Filterung vorgesehen ist.

13. Vorrichtung nach einem der Ansprüche 7 bis 12, **dadurch gekennzeichnet,**
    **dass** die Einrichtungen (21, 31) zur Erzeugung eines Gradientenmagnetfeldes Gradientenspulen sind, die je ein Gradientenmagnetfeld in X- und Y-Richtung oder in X-, Y- und Z-Richtung erzeugen.

**Claims**

1. Method for magnetic resonance examination, in particular nuclear spin tomography,
   in which a static magnetic field is generated in a test chamber,
   in which at least two gradient magnetic fields oriented essentially perpendicular to one another and controlled by a sequence signal are superposed on this static magnetic field,
   in which undesirable alternating electromagnetic forces arise as a result of the gradient magnetic fields,
   in which filtering of at least one of the gradient magnetic fields occurs,
   **characterised in that**
   the sequence signal for at least one gradient magnetic field is subjected to a broad band analog or digital weighting filtering,
   that the filtering occurs in the frequency range between 0 and 2 kHz,
   and that the sequence signal for the at least one gradient magnetic field is filtered so that a destructive interference of the forces occurring in the tomograph is achieved by a phase opposition being generated for two gradient magnetic fields for this frequency range.

2. Method according to Claim 1, **characterised in that** a sensor (34) arranged in the test chamber measures the sound pressure (L) and feeds the measured values to the elements performing the filtering, and that these elements filter the sequence signal adaptively or adaptively with an adaption algorithm.

3. Method according to Claim 1 or 2, **characterised in that** the vibration variations are detected in the test chamber and thereafter corrections are calculated for the filtering processes.

4. Method according to Claim 1, 2 or 3, **characterised in that** the filtering is set to a predetermined function, wherein filter corrections are applied for vibration variations in accordance with the position of the test object in the test chamber.

5. Method according to one of the preceding claims, **characterised in that** the evaluation of measured data of the magnetic resonance examination is adapted to the filtered sequence signal.

6. Method according to one of the preceding claims, **characterised in that** the adaption algorithm has the following formula:

$$h(n+1) = \gamma * h(n) - 2 \mu * x(n) * e(n)$$

where $\gamma$: leakage factor with $0 \leq \gamma \leq 1$,
$e(n) = f(n) = f(t=nT) = f_n$: input function with scanning time T,
n: element of the whole numbers without zero,
$x(n) = g(n)$: measured output signal,
$h(n) = [(t=0), h(t=1T), h(t=2T), ...]$: coefficient vector.

7. Device for magnetic resonance examination, in particular nuclear spin tomogaphy,
   with a first means for generating a static magnetic field,
   with at least two means (21, 31) for generating a gradient magnetic field,
   which generate gradient magnetic fields oriented essentially perpendicular to one another,
   with a common sequence generator (11) for actuation of the means (21, 31) for generating a gradient magnetic field, with a filter (33),

**characterised in that**

an analog or digital filter (33) performing a weighting is connected in front of at least one means (31) for generating a gradient magnetic field, and that the filter operates in the range between 0 and 2 kHz, and that the filter (33) is set so that the means (31) for generating the gradient magnetic field achieves a destructive interference of the mechanical forces occurring in the tomograph by a phase opposition being generated for two gradient magnetic fields for this frequency range.

8. Device according to Claim 7, **characterised in that** the filter (33) is configured as a broad band digital or analog filter system.

9. Device according to Claim 7 or 8, **characterised in that** there is provided an adaptive filter or a filter with an adaption algorithm, in particular an FIR least mean square algorithm.

10. Device according to one of Claims 7 to 9, **characterised in that** the filter (33) is a digital FIR, IIR or Lettis filter.

11. Device according to one of Claims 7, 8 or 9, **characterised in that** acoustic or structurally dynamic sensors (34) are provided in the test chamber, which effect an adaptive correction of the filtering.

12. Device according to one of Claims 7 to 11, **characterised in that** a computer is provided for correction of the filtering in the case of a digital filter system (33).

13. Device according to one of Claims 7 to 12, **characterised in that** the means (21, 31) for generating a gradient magnetic field are gradient coils, which each generate a gradient magnetic field in X and Y direction or in X, Y and Z direction.

## Revendications

1. Procédé pour examiner la résonance magnétique, en particulier la tomographie au spin nucléaire, dans lequel :

   - un champ magnétique statique est généré dans un espace d' examen ;
   - au moins deux champs magnétiques à gradient orientés essentiellement perpendiculairement l'un par rapport à l'autre et commandés par un signal séquentiel sont superposés à ce champ magnétique ;
   - des forces électromagnétiques alternantes non désirées sont générées en raison des champs magnétiques à gradient ; et
   - un filtrage d'au moins un des champs magnétiques à gradient a lieu,

     **caractérisé en ce que** :

   - le signal séquentiel pour au moins un champ magnétique à gradient est filtré avec pondération sur une bande large, analogiquement ou numériquement ;
   - le filtrage a lieu dans la plage de fréquence comprise entre 0 et 2 kHz ; et
   - le signal séquentiel pour le au moins un champ magnétique à gradient est filtré de manière à obtenir une interférence destructive des forces produites dans le tomographe en générant une opposition de phase pour deux champs magnétiques à gradient pour cette plage de fréquence.

2. Procédé selon la revendication 1, **caractérisé en ce qu'**un capteur (34) agencé dans l'espace d'examen mesure la pression acoustique (L) et amène les valeurs mesurées aux éléments exécutant le filtrage et **en ce que** ceux-ci filtrent le signal séquentiel de manière adaptative ou de manière adaptative avec un algorithme d'adaptation.

3. Procédé selon la revendication 1 ou 2, **caractérisé en ce que** les modifications d'oscillation sont saisies dans l'espace d'examen et que des corrections sont ensuite calculées pour les filtrages.

4. Procédé selon la revendication 1, 2 ou 3, **caractérisé en ce que** le filtrage est ajusté sur une fonction prédéterminée, des corrections de filtre pour les modifications d'oscillation étant appliquées selon la position de l'objet à examiner dans l'espace d'examen.

**5.** Procédé selon l'une des revendications précédentes, **caractérisé en ce que** l'évaluation des données de mesure de l'examen de la résonance magnétique est adaptée au signal séquentiel filtré.

**6.** Procédé selon l'une des revendications précédentes, **caractérisé en ce que** l'algorithme d'adaptation présente la formule suivante :

$$h(n+1) = \gamma * h(n) - 2\mu * x(n) * e(n)$$

avec $\gamma$ = facteur de fuite avec $0 \leq \gamma \leq 1$,
$e(n) = f(n) = f(t = nT) = f_n$ : fonction d'entrée avec temps de balayage T
n : élément des nombres entiers sans zéro,
$x(n) = g(n)$ : signal de sortie mesuré,
$h(n) = [(t=0), h(t=1T), h(t=2T),...]$ : vecteur de coefficient.

**7.** Dispositif pour examiner la résonance magnétique, en particulier la tomographie au spin nucléaire, comprenant :

- un premier dispositif de génération pour un champ magnétique statique ;
- au moins deux dispositifs (21, 31) pour générer un champ magnétique à gradient, lesquels génèrent des champs magnétiques à gradient orientés essentiellement perpendiculairement l'un par rapport à l'autre ; et
- un générateur de séquence commun (11) pour piloter les dispositifs (21, 31) afin de générer un champ magnétique à gradient, avec un filtre (33),

     **caractérisé en ce que** :

- un filtre (33) analogue ou numérique exécutant une pondération est monté en amont d'au moins un dispositif (31) pour générer un champ magnétique à gradient ;
- le filtre travaille dans la plage située entre 0 et 2 kHz ; et
- le filtre (33) est ajusté de sorte que le dispositif (31) atteigne une interférence destructive des forces mécaniques produites dans le tomographe pour générer le champ magnétique à gradient, par génération d'une opposition de phase pour deux champs magnétiques à gradient pour cette plage de fréquence.

**8.** Dispositif selon la revendication 7, **caractérisé en ce que** le filtre (33) est réalisé comme système de filtre à bande large, numérique ou analogue.

**9.** Dispositif selon la revendication 7 ou 8, **caractérisé en ce que** l'on a prévu un filtre adaptatif ou un filtre avec un algorithme d'adaptation, en particulier un algorithme « FIR-Least Mean Square ».

**10.** Dispositif selon l'une des revendications 7 à 9, **caractérisé en ce que** le filtre (33) est un filtre FIR, IIR ou Lettis.

**11.** Dispositif selon l'une des revendications 7, 8 ou 9, **caractérisé en ce que** l'on a prévu dans l'espace d'examen des capteurs (34) acoustiques ou à dynamique structurée qui entraînent une correction adaptative du filtrage.

**12.** Dispositif selon l'une des revendications 7 à 11, **caractérisé en ce que** l'on a prévu, dans le cas d'un système de filtre numérique (33), un ordinateur pour corriger le filtrage.

**13.** Dispositif selon l'une des revendications 7 à 12, **caractérisé en ce que** les dispositifs (21, 31) pour générer un champ magnétique à gradient sont des bobines à gradient qui génèrent chacune un champ magnétique à gradient dans les directions X et Y ou dans les directions X, Y et Z.

EP 0 928 426 B1

Fig. 1

Fig. 2

Fig. 3

Fig. 4